# EUROPEAN PATENT APPLICATION

(11) **EP 4 322 205 A1**
(43) Date of publication of application: **14.02.2024**
(21) Application number: 22794679.5
(22) Date of filing: 19.04.2022
(51) Int. Cl.: H01L 23/043, H01L 23/10, H01L 23/367, H01L 23/373

(54) **CHIP PACKAGING STRUCTURE AND ELECTRONIC DEVICE**

(30) Priority: 25.04.2021 CN 202110448700
(71) Applicant: Huawei Technologies Co., Ltd., Shenzhen, Guangdong 518129 (CN)
(72) Inventor: JIAO, Zelong, Shenzhen, Guangdong 518129 (CN); LI, Chungang, Shenzhen, Guangdong 518129 (CN); YANG, Chengpeng, Shenzhen, Guangdong 518129 (CN)
(74) Representative: Maiwald GmbH
(86) International application number: PCT/CN2022/087674
(87) International publication number: WO 2022/228208

(57) **Abstract**

A chip package structure is provided and includes a PCB (10), a chip (20), a package cover (30), a thermal interface material layer (40), and a heat sink (50). The chip (20) is welded to the PCB (10). The package cover (30) is disposed on the PCB (10). The chip (20) is packaged in the package cover (30). The thermal interface material layer (40) covers the chip (20), and is attached to an inner top surface of the package cover (30). The heat sink (50) is disposed on the PCB (10). An assembly space (51) is formed between the heat sink (50) and the PCB (10). The heat sink (50) includes a contact plate (52). A lower end face of the contact plate (52) abuts against an outer top surface of the package cover (30) by using an abutting member (60). A projection of the abutting member (60) in a height direction of the chip package structure covers the chip (20), and is located in a region enclosed by an edge of the outer top surface of the package cover (30). In this way, a hole may be avoided between the thermal interface material layer (40) and the inner top surface of the package cover (30), and heat generated by the chip (20) is transferred well, so that the chip (20) has good heat dissipation performance, and design performance of the chip (20) can be maintained.

## Description

This application claims priority to Chinese Patent Application No. 202110448700.7, filed with the China National Intellectual Property Administration on April 25, 2021 and entitled "CHIP PACKAGE STRUCTURE AND ELECTRONIC DEVICE", which is incorporated herein by reference in its entirety.

### TECHNICAL FIELD

This application pertains to the field of chip packaging technologies, and in particular, to a chip package structure and an electronic device.

### BACKGROUND

In recent years, with the progress of technologies, chip technologies have also developed rapidly towards high speed, high density, and high performance. As an important factor in chip packaging, heat dissipation directly affects design performance of a chip after packaging.

In the conventional technology, heat generated by the chip in a package structure needs to be conducted to a heat sink by using a thermal interface material. However, due to existence of a machining tolerance and degradation of elastic force of the thermal interface material with time, a hole is easily formed between the thermal interface material and a package cover in the package structure, resulting in great reduction in heat dissipation performance of the chip.

### SUMMARY

An objective of embodiments of this application is to provide a chip package structure and an electronic device, to suppress or eliminate a phenomenon that a hole is easily formed between a thermal interface material and a package cover in the chip package structure, to maintain good heat dissipation performance of a chip in the package structure.

To achieve the foregoing objective, the following technical solutions are used in this application.

According to a first aspect, a chip package structure is provided, including a PCB, a chip, a package cover, a thermal interface material layer, and a heat sink. The chip is welded to the PCB. The package cover is disposed on the PCB. The chip is packaged in the package cover. The thermal interface material layer covers the chip, and is attached to an inner top surface of the package cover.

The heat sink is disposed on the PCB. An assembly space is formed between the heat sink and the PCB. The chip and the package cover are both located in the assembly space. A contact plate is provided on a side, facing the package cover, of the heat sink. A lower end face of the contact plate abuts against an outer top surface of the package cover by using an abutting member. A projection of the abutting member in a height direction of the chip package structure covers the chip, and is located in a region enclosed by an edge of the outer top surface of the package cover.

The abutting member disposed between the outer top surface of the package cover and the lower end face of the contact plate may be a hard object or an elastic object. When the abutting member is a hard object, the abutting member may transfer constant pressing force to the package cover. When the heat sink is a floating heat sink, the abutting member may also provide elastic pressing force for the package cover. When the abutting member is an elastic object, regardless of whether the heat sink is a floating heat sink or a fastened heat sink, the abutting member can provide elastic pressing force for the package cover.

The chip of the chip package structure provided in this embodiment of this application is welded to the PCB, and is packaged in the package cover. The thermal interface material layer is filled between the inner top surface of the package cover and the chip. The outer top surface of the package cover elastically abuts against an abutting region of the lower end face of the contact plate. The projection of the abutting member between the lower end face of the contact plate and the outer top surface of the package cover in the height direction of the chip package structure covers the chip, and is located in the region enclosed by the edge of the outer top surface of the package cover. In this way, abutting force applied by the abutting member to the package cover can be concentrated at a position of the package cover opposite to the chip, so that stress on the thermal interface material layer between the inner top surface of the package cover and the chip can also be concentrated. In this way, adequate pressure from the inner top surface of the package cover and a surface of the chip on the thermal interface material layer can be maintained, so that thermal interface material layer can always be attached to the inner top surface of the package cover and the surface of the chip, and a hole between the thermal interface material layer and the inner top surface of the package cover is avoided. In this way, heat generated by the chip can be transferred well, so that the chip has good heat dissipation performance, and design performance of the chip can be maintained during long-term operation of the chip package structure.

Optionally, the abutting member is formed integrally with the lower end face of the contact plate.

Optionally, the abutting member includes an abutting part and a thermally conductive layer. The abutting part is formed integrally with the lower end face of the contact plate. The thermally conductive layer is disposed between the abutting part and the outer top surface of the package cover. In this way, on the one hand, the abutting part is formed integrally with the lower end face of the contact plate, so that reliability of connection between the abutting member and the contact plate can be improved. On the other hand, the thermally conductive layer can also fill a gap that may exist between the abutting part and the package cover.

Optionally, the abutting member is disposed on the lower end face of the contact plate and abuts against the outer top surface of the package cover. The abutting member is an elastic thermal interface material member or a metal dome.

Optionally, the abutting member includes a metal dome and a thermally conductive layer. The metal dome is disposed on the lower end face of the contact plate. The thermally conductive layer is disposed between a bulging part of the metal dome and the outer top surface of the package cover. Projections of the metal dome and the thermally conductive layer in the height direction of the chip package structure both cover the chip, and are both located in the region enclosed by the edge of the outer top surface of the package cover.

Optionally, the abutting member includes a spring component and an abutting piece. The spring component is disposed on the lower end face of the contact plate. The abutting piece is connected to the spring component and abuts against the outer top surface of the package cover. A projection of the abutting piece in the height direction of the chip package structure covers the chip.

Optionally, the abutting member is disposed on the outer top surface of the package cover and abuts against the lower end face of the contact plate.

Optionally, the abutting member is an elastic thermal interface material member.

Optionally, the abutting member is formed integrally with the package cover.

Optionally, the abutting member includes an abutting part and a thermally conductive layer. The abutting part is formed integrally with the outer top surface of the package cover. The thermally conductive layer is disposed between the abutting part and the lower end face of the contact plate.

Optionally, the elastic thermal interface material member is an elastic phase-change metal sheet or a silicone gasket.

Optionally, the thermally conductive layer is a silicone pad layer or a silicone layer.

Optionally, the thermal interface material layer is a silicone layer or a graphene thermal pad.

Optionally, the heat sink further includes a fastening post, an elastic member, and a plurality of heat sink fins disposed on the contact plate. The fastening post is disposed on the PCB. An upper end of the elastic member is connected to the fastening post. A lower end of the elastic member is connected to the contact plate. The elastic member applies elastic force to the contact plate.

Optionally, the heat sink further includes a fastening post and a plurality of heat sink fins disposed on the contact plate, and the contact plate is connected to the fastening post.

According to a second aspect, an electronic device is provided, including a mainboard and the foregoing chip package structure. The chip package structure is disposed on the mainboard.

The electronic device provided in this embodiment of this application includes the foregoing chip package structure, and the foregoing chip package structure can prevent a hole between the thermal interface material layer and the inner top surface of the package cover by concentrating stress on the thermal interface material layer inside the chip package structure, so that the chip has good heat dissipation performance, and design performance of the chip can also be achieved. Therefore, operation performance of the electronic device is also improved.

### BRIEF DESCRIPTION OF DRAWINGS

FIG. 1 is a schematic diagram 1 of a structure of a chip package structure according to an embodiment of this application;
FIG. 2 is a schematic diagram 2 of a structure of a chip package structure according to an embodiment of this application;
FIG. 3 is a schematic diagram 3 of a structure of a chip package structure according to an embodiment of this application;
FIG. 4 is a schematic diagram 4 of a structure of a chip package structure according to an embodiment of this application;
FIG. 5 is a schematic diagram 5 of a structure of a chip package structure according to an embodiment of this application;
FIG. 6 is a schematic diagram 6 of a structure of a chip package structure according to an embodiment of this application;
FIG. 7 is a schematic diagram 7 of a structure of a chip package structure according to an embodiment of this application;
FIG. 8 is a schematic diagram 8 of a structure of a chip package structure according to an embodiment of this application;
FIG. 9 is a schematic diagram 9 of a structure of a chip package structure according to an embodiment of this application; and
FIG. 10 is a diagram of heat dissipation performance comparison between a chip package structure and an existing package structure according to an embodiment of this application.

### Reference numerals:

10-PCB; 11-Substrate; 12-Spherical solder joint
13-Copper foil; 20-Chip; 30-Package cover
31-Package adhesive; 32-Second abutting member; 40-Thermal interface material layer
50-Heat sink; 51-Assembly space; 52-Contact plate
53-Fastening post; 54-Elastic member; 55-Heat sink fin
60-Abutting member; 61-Abutting part; 62-Thermally conductive layer
63-Elastic thermal interface material member; 64-Metal dome 65-Spring component
66-Abutting piece

### DESCRIPTION OF EMBODIMENTS

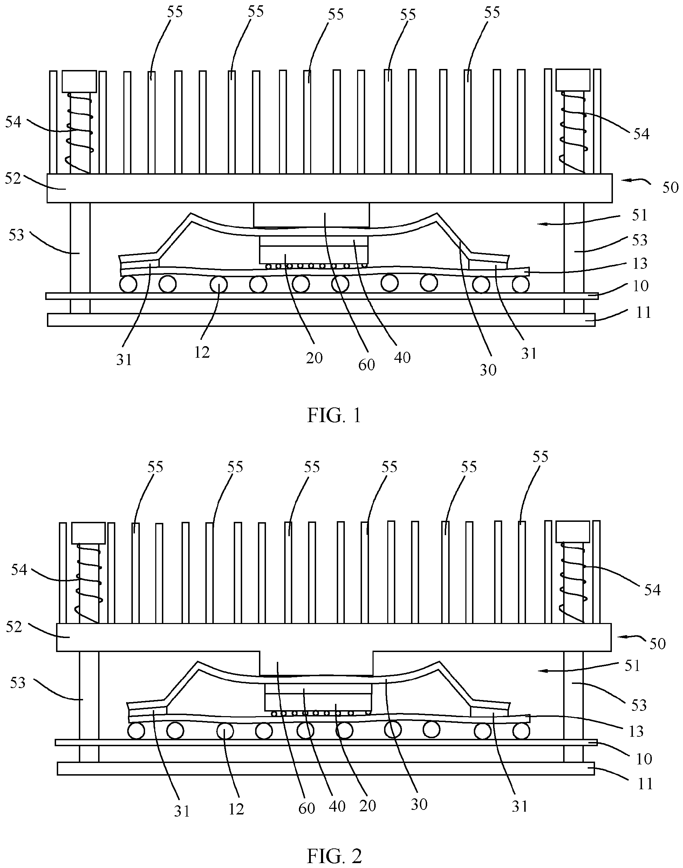

The following describes embodiments of this application in detail. Examples of embodiments are shown in the accompanying drawings. Same or similar reference numerals are always used to represent same or similar elements or elements with same or similar functions. The embodiments described below with reference to FIG. 1 to FIG. 10 are examples and intended to explain this application, but shall not be understood as a limitation on this application.

In the description of this application, it should be understood that orientation or positional relationships indicated by the terms "top", "bottom", "inside", "outside", and the like are based on orientation or positional relationships shown in the accompanying drawings, are merely for ease of describing this application and simplifying the description, but do not indicate or imply that an apparatus or an element mentioned in this application needs to have a specific orientation or be constructed and operated in a specific orientation, and therefore shall not be construed as a limitation on this application.

In addition, the terms "first" and "second" are merely intended for a purpose of description, and shall not be understood as an indication or implication of relative importance or an implicit indication of a quantity of indicated technical features. Therefore, a feature limited by "first" or "second" may explicitly or implicitly include one or more such features. In the description of this application, "a plurality of" means two or more, unless otherwise specifically defined.

In this application, unless otherwise expressly specified and defined, terms such as "install", "connect", "connected to", and "fasten" should be understood in a broad sense. For example, a "connection" may be a fixed connection, a detachable connection, or an integrated connection, may be a mechanical connection or an electrical connection, or may be a direct connection, an indirect connection through an intermediate medium, or a connection inside two elements or an interaction relationship between two elements. A person of ordinary skill in the art may understand specific meanings of the foregoing terms in this application based on specific situations.

For ease of understanding, the following professional nouns are first briefly described in this application.

Thermal interface material (Thermal Interface Material, TIM): It is a material used to coat a part between a heat dissipation component and a heat emitting component to reduce thermal contact resistance between the heat dissipation component and the heat emitting component.

Coefficient of thermal expansion (Coefficient of thermal expansion, CTE): It is a regular coefficient in which a geometrical characteristic of an object changes with temperature when the object expands and contracts due to a temperature change.

In the conventional technology, a chip in a package structure is packaged in a cover (also referred to as a heat spreader). Heat generated by the chip needs to be transferred to the cover by using a thermal interface material, and then is transferred by the cover to a heat sink. In this process, coefficients of thermal expansion of the thermal interface material, the cover, and the chip may not match, and elastic force of an elastic thermally conductive material that is filled between the cover and the heat sink is degraded. As a result, bonding tightness between a thermal interface material layer and the cover that are in the package structure is likely to decrease, and a hole is formed between the thermal interface material layer and the cover, leading to a great decrease in heat dissipation performance of the chip.

In conclusion, embodiments of this application provide a chip package structure and an electronic device, to suppress or eliminate a phenomenon that a hole is easily formed between a thermal interface material and a package cover 30 in the chip package structure, to maintain good heat dissipation performance of a chip 20 in the package structure.

Refer to FIG. 1. According to a first aspect, an embodiment of this application provides a chip package structure, including a PCB 10, a chip 20, a package cover 30, a thermal interface material layer 40, and a heat sink 50. The chip package structure in this embodiment may be used for a plurality of types of package of the chip 20, for example, pin grid array package, ball grid array package, quad flat package, and chip 20 on board package.

The chip 20 is welded to the PCB 10. Specifically, the chip 20 may first be welded to a metal foil such as a copper foil 13 by using arrayed spherical solder joints 12, and then the copper foil 13 is welded to the PCB 10 by using arrayed spherical solder joints 12. The PCB 10 together with the heat sink 50 is assembled on a substrate 11.

The package cover 30 is disposed on the PCB 10. The chip 20 is packaged in the package cover 30. Specifically, the package cover 30 is disposed on the PCB 10 in a sealed manner by using package adhesive 31. A space is formed between the package cover 30 and the PCB 10. The chip 20 is located in the space.

The thermal interface material layer 40 covers the chip 20, and is attached to an inner top surface of the package cover 30. In this embodiment, thermal conductivity of the thermal interface material layer 40 filled between the chip 20 and the inner top surface of the package cover 30 is first considered. Then, it is considered that the thermal interface material layer 40 may be elastic or may not be elastic.

The heat sink 50 is disposed on the PCB 10. The heat sink 50 may be a fastened heat sink 50 or a floating heat sink. When the heat sink 50 is a fastened heat sink, the heat sink 50 applies constant pressure to an outer top surface of the package cover 30. When the heat sink 50 is a floating heat sink 50, the heat sink 50 applies elastic force to an outer top surface of the package cover 30.

Specifically, an assembly space 51 is formed between the heat sink 50 and the PCB 10. The chip 20 and the package cover 30 are both located in the assembly space 51. A contact plate 52 is provided on a side, facing the package cover 30, of the heat sink 50. A lower end face of the contact plate 52 abuts against the outer top surface of the package cover 30 by using an abutting member 60. A projection of the abutting member 60 in a height direction of the chip package structure covers the chip 20, and is located in a region enclosed by an edge of the outer top surface of the package cover 30.

For example, the abutting member 60 disposed between the outer top surface of the package cover 30 and the lower end face of the contact plate 52 may be a hard object or an elastic object. When the abutting member 60 is a hard object, the abutting member 60 may transfer constant pressing force to the package cover 30. When the heat sink 50 is a floating heat sink, the abutting member 60 may also provide elastic pressing force for the package cover 30. When the abutting member 60 is an elastic object, regardless of whether the heat sink 50 is a floating heat sink or a fastened heat sink, the abutting member 60 can provide elastic pressing force for the package cover 30.

Refer to FIG. 1. The following further describes the chip package structure provided in this embodiment of this application. The chip 20 of the chip package structure provided in this embodiment of this application is welded to the PCB 10, and is packaged in the package cover 30. The thermal interface material layer 40 is filled between the inner top surface of the package cover 30 and the chip 20. The outer top surface of the package cover 30 elastically abuts against an abutting region 521 of the lower end face of the contact plate 52. The projection of the abutting member 60 between the lower end face of the contact plate 52 and the outer top surface of the package cover 30 in the height direction of the chip package structure covers the chip 20, and is located in the region enclosed by the edge of the outer top surface of the package cover 30. In this way, abutting force applied by the abutting member 60 to the package cover 30 can be concentrated at a position of the package cover 30 opposite to the chip 20, so that stress on the thermal interface material layer 40 between the inner top surface of the package cover 30 and the chip 20 can also be concentrated. In this way, adequate pressure from the inner top surface of the package cover 30 and a surface of the chip 20 on the thermal interface material layer 40 can be maintained, so that the thermal interface material layer 40 can always be attached to the inner top surface of the package cover 30 and the surface of the chip 20, and a hole between the thermal interface material layer 40 and the inner top surface of the package cover 30 is avoided. In this way, heat generated by the chip 20 can be transferred well, so that the chip 20 has good heat dissipation performance, and design performance of the chip 20 can be maintained during long-term operation of the chip package structure.

In some other embodiments of this application, as shown in FIG. 2, the abutting member 60 may be formed integrally with the contact plate 52. In this way, manufacturing costs of the abutting member 60 and the contact plate 52 may be reduced, and manufacturing efficiency of the abutting member 60 and the contact plate 52 may be improved. In addition, the abutting member 60 may be a boss formed by extending the lower end face of the contact plate 52.

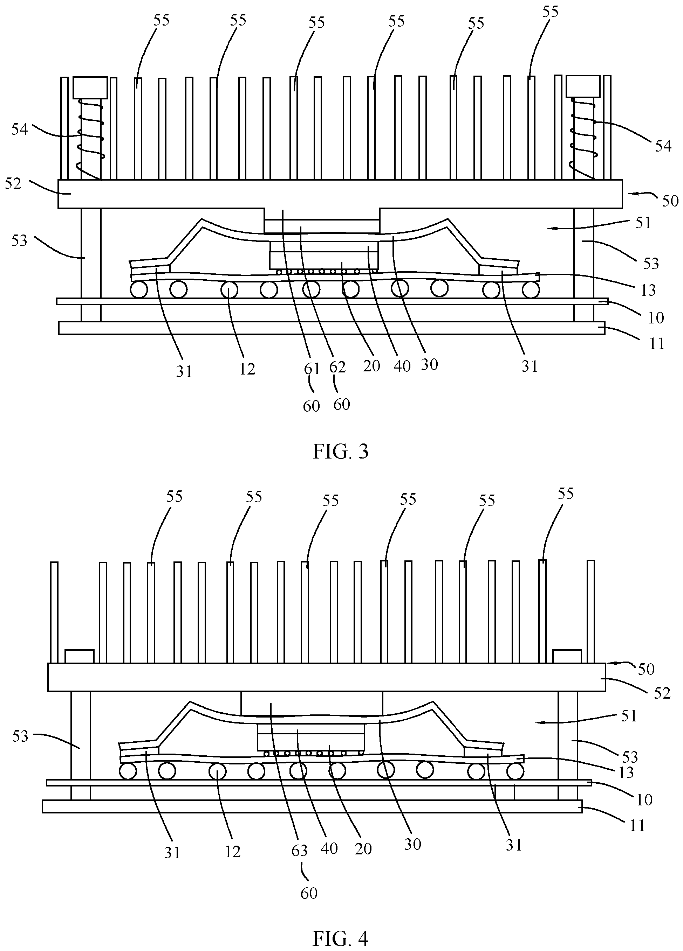

In some other embodiments of this application, as shown in FIG. 3, the abutting member 60 includes an abutting part 61 and a thermally conductive layer 62. The abutting part 61 is formed integrally with the lower end face of the contact plate 52. The thermally conductive layer 62 is disposed between the abutting part 61 and the outer top surface of the package cover 30. Specifically, the abutting member 60 includes the abutting part 61 and the thermally conductive layer 62. In this way, on the one hand, the abutting part 61 is formed integrally with the lower end face of the contact plate 52, so that reliability of connection between the abutting member 60 and the contact plate 52 can be improved. On the other hand, the thermally conductive layer 62 can also fill a gap that may exist between the abutting part 61 and the package cover 30, so that heat may be more efficiently transferred between the abutting part 61 and the package cover 30.

In some other embodiments of this application, as shown in FIG. 4, the abutting member 60 is disposed on the lower end face of the contact plate 52 and elastically abuts against the outer top surface of the package cover 30. The abutting member 60 is an elastic thermal interface material member 63. Specifically, regardless of whether the heat sink 50 is a fastened heat sink 50 or a floating heat sink 50, the abutting member 60 is disposed on the lower end face of the contact plate 52, and the abutting member 60 is set to be the elastic thermal interface material member 63. In this way, the abutting member 60 may elastically abut against the outer top surface of the package cover 30 by using elastic force of the abutting member 60. In addition, the elastic force output by the abutting member 60 may be well controlled by adjusting a parameter such as an elasticity coefficient of the abutting member 60, so that elastic force applied to the outer top surface of the package cover 30 and pressure conducted to the thermal interface material layer 40 may be accurately controlled.

The abutting member 60 is set to be the elastic thermal interface material member 63. In this way, in addition to a function of outputting the elastic force, the abutting member 60 has a good heat transfer function, so that overall heat dissipation performance of the chip package structure is further improved.

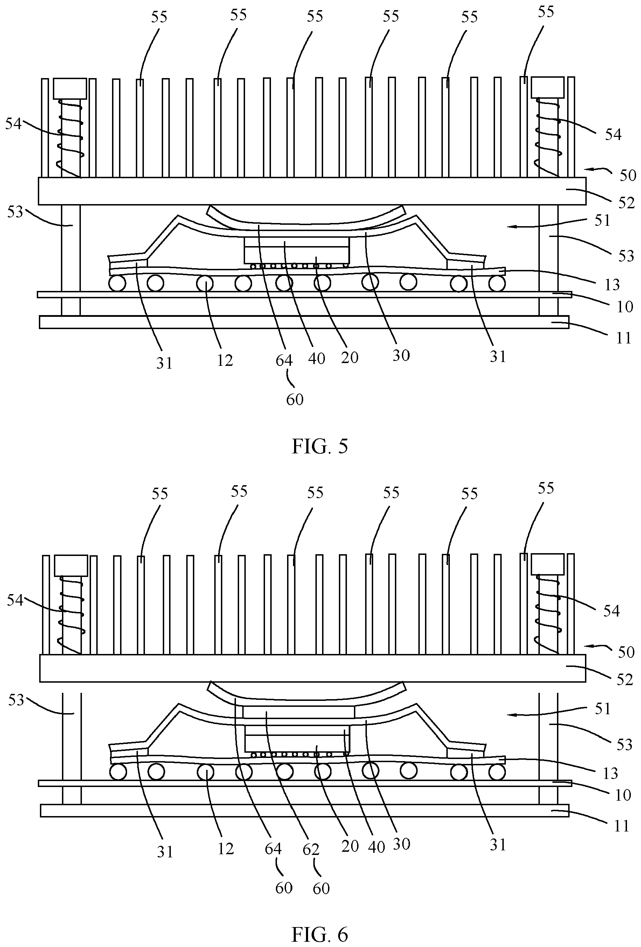

In some other embodiments of this application, as shown in FIG. 5, the abutting member 60 may alternatively be a metal dome 64. A projection of the metal dome 64 in the height direction of the chip package structure covers the chip 20. Specifically, another specific form of the abutting member 60 may be the metal dome 64. The metal dome 64 can output elastic force to the outer top surface of the package cover 30 under an action of the elastic force. Selecting the metal dome 64 as the abutting member 60 can also reduce manufacturing costs of the abutting member 60, and well match coefficients of thermal expansion of the contact plate 52 and the package cover 30, so that the abutting member 60 can be stably welded or fastened to the lower end face of the contact plate 52 with adhesive.

In some other embodiments of this application, as shown in FIG. 6, the abutting member includes a metal dome and a thermally conductive layer 62. The metal dome is disposed on the lower end face of the contact plate. The thermally conductive layer 62 is disposed between a bulging part of the metal dome and the outer top surface of the package cover. Projections of the metal dome and the thermally conductive layer 62 in the height direction of the chip package structure both cover the chip, and are both located in the region enclosed by the edge of the outer top surface of the package cover.

Specifically, in another manner of disposing the abutting member, the thermally conductive layer 62 is disposed between the bulging part of the metal dome and the outer top surface of the package cover. In this way, based on the metal dome, the thermally conductive layer 62 can also fill a gap that may exist between the metal dome and the package cover 30, so that heat may be more efficiently transferred between the metal dome and the package cover 30.

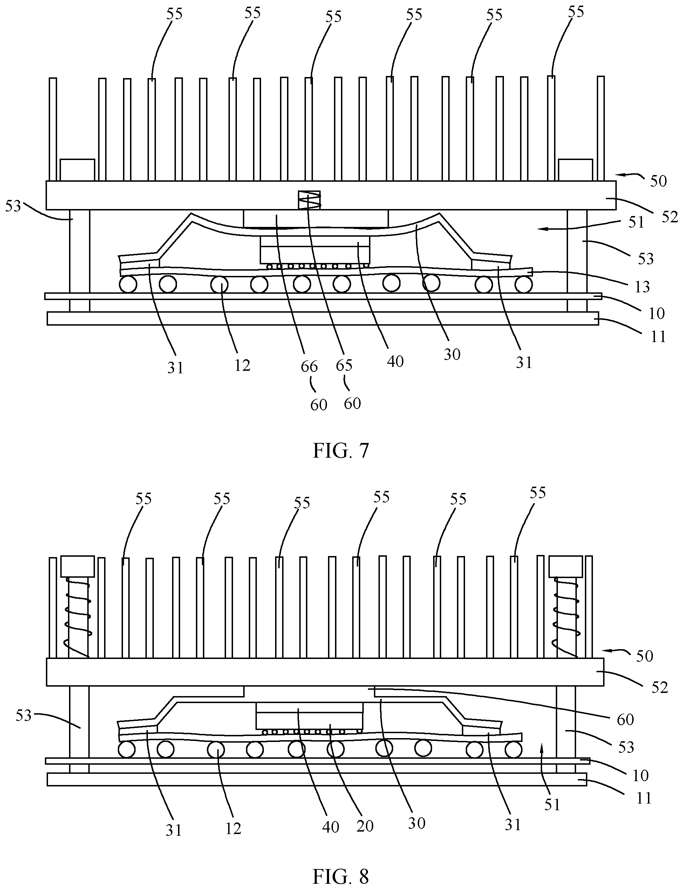

In some other embodiments of this application, as shown in FIG. 7, the abutting member 60 may alternatively include a spring component 65 and an abutting piece 66. The spring component 65 is disposed on the lower end face of the contact plate 52. The abutting piece 66 is connected to the spring component 65 and abuts against the outer top surface of the package cover 30. A projection of the abutting piece 66 in the height direction of the chip package structure covers the chip 20.

Specifically, the abutting member 60 includes the spring component 65 and the abutting piece 66. In this way, the spring component 65 disposed on the lower end face of the contact plate 52 can output elastic force to the abutting piece 66, so that the abutting piece 66 can elastically abut against the outer top surface of the package cover 30. Because the elastic force of the spring component 65 can be determined by selecting a specific specification of the spring component 65, the elastic force applied to the outer top surface of the package cover 30 is also accurately controlled.

In some other embodiments of this application, as shown in FIG. 8, as another concept of an assembly position of the abutting member 60, the abutting member 60 may be disposed on the outer top surface of the package cover 30, and abuts against the lower end face of the contact plate 52. In this way, the abutting member 60 can also implement concentration of stress on the thermal interface material layer 40 by using reaction force applied to the lower end face of the contact plate 52, so that the thermal interface material layer 40 can always be attached to the inner top surface of the package cover 30 and a surface of the chip 20, a hole between the thermal interface material layer 40 and the inner top surface of the package cover 30 is avoided.

In some other embodiments of this application, based on the solution in which the abutting member 60 is disposed on the outer top surface of the package cover 30, the abutting member 60 may alternatively be specifically selected to be an elastic thermal interface material member 63. In this way, regardless of whether the heat sink 50 is a floating heat sink 50 or a fastened heat sink 50, the abutting member 60 may abut against the abutting region 521 of the contact plate 52, so that elastic abutting between the package cover 30 and the contact plate 52 is implemented. As described above, because the elastic thermal interface material member 63 has a good heat transfer function, overall heat dissipation efficiency of the chip package structure is improved while elastic abutting between the package cover 30 and the contact plate 52 is implemented.

In some other embodiments of this application, the elastic thermal interface material member 63 is an elastic phase-change metal sheet or a silicone gasket. Specifically, because the elastic thermal interface material member 63 needs to consider both elastic performance and heat transfer performance, the elastic thermal interface material member 63 may be specifically selected to be the elastic phase-change metal sheet or the silicone gasket. In addition, in the chip package structure, the elastic thermal interface material member 63 does not implement a main heat transfer function, so that when there is a conflict between the elastic performance and the heat transfer performance, the elastic performance may be preferentially considered.

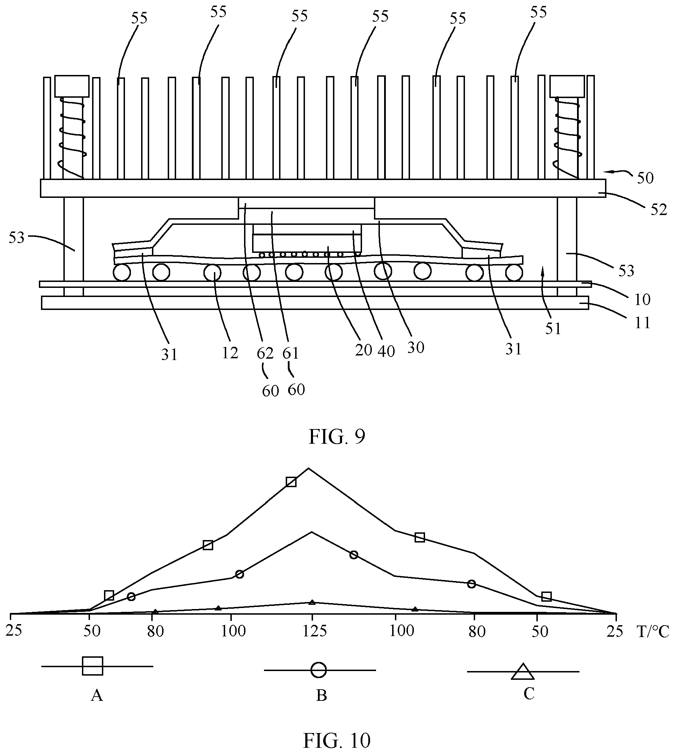

In some other embodiments of this application, as shown in FIG. 9, similar to the solution in which the abutting member 60 is disposed on the lower end face of the contact plate 52, in the solution in which the abutting member 60 is disposed on the outer top surface of the package cover 30, the abutting member 60 may also include an abutting part 61 and a thermally conductive layer 62. The abutting part 61 is formed integrally with the outer top surface of the package cover 30. The thermally conductive layer 62 is disposed between the abutting part 61 and the lower end face of the contact plate 52. In this way, on the one hand, the abutting part 61 is formed integrally with the outer top surface of the package cover 30, so that reliability of connection between the abutting member 60 and the package cover 30 can be improved. On the other hand, the thermally conductive layer 62 can also fill a gap that may exist between the abutting part 61 and the contact plate 52, so that heat may be more efficiently transferred between the abutting part 61 and the contact plate 52.

In some other embodiments of this application, the thermally conductive layer 62 may be a silicone pad layer or a silicone layer. In this case, because the silicone pad layer and the silicone layer have good thermal conductivity, the thermally conductive layer 62 also has good thermal conductivity. The silicone pad layer further has good elastic performance, so that the thermally conductive layer 62 can also provide specific elastic force.

In some other embodiments of this application, the thermal interface material layer 40 is a silicone layer or a graphene thermal pad. Specifically, the thermal interface material layer 40 is filled or disposed between the package cover 30 and the chip 20, and mainly achieves heat transfer performance, and other performance such as elastic performance does not need to be considered. Therefore, when the thermal interface material layer 40 is specifically selected, the heat transfer performance of the thermal interface material layer 40 is the focus of consideration. The thermal interface material layer 40 is specifically selected to be the silicone layer or the graphene thermal pad, so that heat may be efficiently transferred between the chip 20 and the package cover 30 due to good heat transfer performance of the silicone layer or the graphene thermal pad.

In some other embodiments of this application, as shown in FIG. 1, the heat sink 50 further includes a fastening post 53, an elastic member 54, and a plurality of heat sink fins 55 disposed on the contact plate 52. The fastening post 53 is disposed on the PCB 10. An upper end of the elastic member 54 is connected to the fastening post 53. A lower end of the elastic member 54 is connected to the contact plate 52. The elastic member 54 applies elastic force to the contact plate 52.

Specifically, in this embodiment, the heat sink 50 is a floating heat sink 50, and upper and lower ends of the elastic member 54 of the heat sink 50 are respectively connected to the fastening post 53 and the contact plate 52, so that the contact plate 52 can be subject to the elastic force applied by the elastic member 54. Therefore, the abutting member 60 can transfer elastic pressing force to the outer top surface of the package cover 30. In this way, on the one hand, the abutting member 60 can apply concentrated force to a position of the package cover 30 corresponding to the chip 20, to avoid a hole between the thermal interface material layer 40 and the inner top surface of the package cover 30. On the other hand, heat of the chip 20 transferred by the thermal interface material layer can be transferred to the contact plate 52 by using the package cover 30 and the abutting member 60, and then dissipated to the outside by using the plurality of heat sink fins 55 disposed on the contact plate 52, to implement heat dissipation of the chip 20.

In some other embodiments of this application, as shown in FIG. 4, the heat sink 50 may alternatively include a fastening post 53 and a plurality of heat sink fins 55 disposed on the contact plate 52, and the contact plate 52 is connected to the fastening post 53.

Specifically, in this embodiment, the heat sink 50 does not have an elastic member 54, and the fastening post 53 and the contact plate 52 of the heat sink 50 are connected to each other. Therefore, the heat sink 50 is a fastened heat sink 50, and the contact plate 52 no longer has a function of outputting elastic force to the package cover 30. Based on this, the abutting member 60 may be a combination of the foregoing spring component 65 and abutting piece 66, or may be an elastic component such as the foregoing metal dome 64 and elastic thermal interface material member 63. Therefore, when the contact plate 52 of the heat sink 50 does not have the function of applying the elastic force to the package cover 30, the elastic force may be applied to the package cover 30 only by using the abutting member 60.

The following compares and analyzes heat dissipation effects of the chip package structure provided in embodiments of this application with heat dissipation effects of an existing solution in which a chip package structure has no heat sink and a conventional heat dissipation solution for a chip package structure.

In an experiment, the solution in which a chip package structure has no heat sink, the conventional heat dissipation solution for a chip package structure, and the chip package structure provided in embodiments of this application are selected. A temperature first rises from 25°C to 125°C, and then drops from 125°C to 25°C.

As shown in FIG. 10, A in FIG. 10 indicates that the solution in which a chip package structure has no heat sink. It may be learned that in the temperature range of 25°C to 125°C, a chip temperature rise in the solution in which a chip package structure has no heat sink is quite significant.

B in FIG. 10 indicates that conventional heat dissipation solution for a chip package structure. It may be learned that in the temperature range of 25°C to 125°C, a chip temperature rise in the conventional heat dissipation solution for a chip package structure is less than that in the solution in which a chip package structure has no heat sink, but there is a significant temperature rise as the temperature increases.

C in FIG. 10 indicates the chip package structure provided in embodiments of this application. It may be learned that in the temperature range of 25°C to 125°C, from 25°C to 125°C, a chip temperature rise of the chip package structure provided in embodiments of this application remains gentle, and an increase amplitude is far less than those in the foregoing two existing solutions. It may be learned that compared with an existing chip package solution, the chip package structure provided in embodiments of this application may better suppress a hole between the thermal interface material layer 40 and the package cover by applying elastic force to the package cover and concentrating stress on the package cover in different application scenarios. In addition, the chip package structure has better designability and coverage and better hole suppression effects, so that better heat dissipation performance of the chip can be achieved.

According to a second aspect, an embodiment of this application further provides an electronic device, including a mainboard and the foregoing chip package structure. The chip package structure is disposed on the mainboard. In this embodiment, the electronic device may be a mobile phone, a personal computer, a communication base station, a tablet computer, or the like. This is not limited in this embodiment of this application.

The electronic device provided in this embodiment of this application includes the foregoing chip package structure, and the foregoing chip package structure can prevent a hole between the thermal interface material layer 40 and the inner top surface of the package cover 30 by concentrating stress on the thermal interface material layer 40 inside the chip package structure, so that the chip 20 has good heat dissipation performance, and design performance of the chip 20 can also be achieved. Therefore, operation performance of the electronic device is also improved.

The foregoing descriptions are merely preferred embodiments of this application, but are not intended to limit this application. Any modification, equivalent replacement, or improvement made without departing from the spirit and principle of this application shall fall within the protection scope of this application.

## Claims

1. A chip package structure, comprising:
a PCB;
a chip, wherein the chip is welded to the PCB;
a package cover, wherein the package cover is disposed on the PCB, and the chip is packaged in the package cover;
a thermal interface material layer, wherein the thermal interface material layer covers the chip, and is attached to an inner top surface of the package cover; and
a heat sink, wherein the heat sink is disposed on the PCB, an assembly space is formed between the heat sink and the PCB, the chip and the package cover are both located in the assembly space, a contact plate is provided on a side, facing the package cover, of the heat sink, a lower end face of the contact plate abuts against an outer top surface of the package cover by using an abutting member, and a projection of the abutting member in a height direction of the chip package structure covers the chip, and is located in a region enclosed by an edge of the outer top surface of the package cover.

2. The chip package structure according to claim 1, wherein the abutting member is formed integrally with the lower end face of the contact plate.

3. The chip package structure according to claim 1, wherein the abutting member comprises an abutting part and a thermally conductive layer, the abutting part is formed integrally with the lower end face of the contact plate, and the thermally conductive layer is disposed between the abutting part and the outer top surface of the package cover.

4. The chip package structure according to claim 1, wherein the abutting member is disposed on the lower end face of the contact plate and abuts against the outer top surface of the package cover; and the abutting member is an elastic thermal interface material member or a metal dome.

5. The chip package structure according to claim 1, wherein the abutting member comprises a metal dome and a thermally conductive layer, the metal dome is disposed on the lower end face of the contact plate, the thermally conductive layer is disposed between a bulging part of the metal dome and the outer top surface of the package cover, and projections of the metal dome and the thermally conductive layer in the height direction of the chip package structure both cover the chip, and are both located in the region enclosed by the edge of the outer top surface of the package cover.

6. The chip package structure according to claim 1, wherein the abutting member comprises a spring component and an abutting piece, the spring component is disposed on the lower end face of the contact plate, the abutting piece is connected to the spring component and abuts against the outer top surface of the package cover, and a projection of the abutting piece in the height direction of the chip package structure covers the chip.

7. The chip package structure according to claim 1, wherein the abutting member is disposed on the outer top surface of the package cover and abuts against the lower end face of the contact plate.

8. The chip package structure according to claim 7, wherein the abutting member is an elastic thermal interface material member.

9. The chip package structure according to claim 7, wherein the abutting member is formed integrally with the package cover.

10. The chip package structure according to claim 7, wherein the abutting member comprises an abutting part and a thermally conductive layer, the abutting part is formed integrally with the outer top surface of the package cover, and the thermally conductive layer is disposed between the abutting part and the lower end face of the contact plate.

11. The chip package structure according to claim 4 or 8, wherein the elastic thermal interface material member is an elastic phase-change metal sheet or a silicone gasket.

12. The chip package structure according to claim 3, 5, or 10, wherein the thermally conductive layer is a silicone pad layer or a silicone layer.

13. The chip package structure according to any one of claims 1 to 12, wherein the thermal interface material layer is a silicone layer or a graphene thermal pad.

14. The chip package structure according to any one of claims 1 to 12, wherein the heat sink further comprises a fastening post, an elastic member, and a plurality of heat sink fins disposed on the contact plate, the fastening post is disposed on the PCB, an upper end of the elastic member is connected to the fastening post, a lower end of the elastic member is connected to the contact plate, and the elastic member applies elastic force to the contact plate.

15. The chip package structure according to any one of claims 1 to 12, wherein the heat sink further comprises a fastening post and a plurality of heat sink fins disposed on the contact plate, and the contact plate is connected to the fastening post.

16. An electronic device, comprising a mainboard and the chip package structure according to any one of claims 1 to 15, wherein the chip package structure is disposed on the mainboard.
